# EUROPEAN PATENT APPLICATION

(11) **EP 4 742 840 A1**
(43) Date of publication of application: **13.05.2026**
(21) Application number: 24212231.5
(22) Date of filing: 11.11.2024
(51) Int. Cl.: H05K 1/11, H05K 3/00, H05K 3/42

(54) **ELECTRONIC BOARD WITH PLATED THROUGH HOLE AND AXIAL AND RADIAL ANNULAR PROTRUSIONS**

(71) Applicant: AT & S Austria Technologie & Systemtechnik Aktiengesellschaft, 8700 Leoben-Hinterberg (AT)
(72) Inventor: KLEINSCHUSTER, Harald, 8382 Mogersdorf (AT)
(74) Representative: Dilg, Haeusler, Schindelmann Patentanwaltsgesellschaft mbH

(57) **Abstract**

An electronic board (100) which comprises a stack (102) comprising at least one electrically insulating layer structure (104) and a plurality of electrically conductive layer structures (106, 108), wherein one of said plurality of electrically conductive layer structures (106) is provided on one main surface (110) of said at least one electrically insulating layer structure (104) and a further one of said plurality of electrically conductive layer structures (108) is provided on an opposing further main surface (112) of said at least one electrically insulating layer structure (104), a through hole (120) formed in the stack (102) and being laterally delimited by conductive material, at least one plating layer (122) provided on at least part of both opposing main surfaces (114, 116) of the stack (102) and on a lateral wall (118) of the stack (102), an axial annular protrusion (126, 128) provided at one extremity of the through hole (120), and a radial annular protrusion (130, 132, 134) provided at the lateral wall (118) of the stack (102).

## Description

### Field of the Invention

The invention relates to an electronic board, and to a method of manufacturing an electronic board.

### Technological Background

In the context of growing product functionalities of electronic boards and increasing miniaturization of an electronic board such as printed circuit boards, increasingly more powerful packages are being employed, which have a plurality of contacts or connections, with smaller and smaller spacing between these contacts. In particular, electronic boards shall be mechanically robust and electrically reliable so as to be operable even under harsh conditions.

Conventional approaches of forming electronic boards are still challenging.

### Summary of the Invention

There may be a need to form a compact and reliable electronic board.

According to an exemplary embodiment of the invention, an electronic board is provided which comprises a stack comprising at least one electrically insulating layer structure and a plurality of electrically conductive layer structures, wherein one of said plurality of electrically conductive layer structures is provided on one main surface of said at least one electrically insulating layer structure and a further one of said plurality of electrically conductive layer structures is provided on an opposing further main surface of said at least one electrically insulating layer structure, a through hole formed in the stack and being laterally delimited by conductive material, at least one plating layer provided on at least part of both opposing main surfaces of the stack and on at least part of a lateral wall of the stack, an axial annular protrusion provided at one extremity of the through hole, and a radial annular protrusion provided at the lateral wall of the stack.

According to another exemplary embodiment of the invention, a method of manufacturing an electronic board is provided, wherein the method comprises providing a stack comprising at least one electrically insulating layer structure and a plurality of electrically conductive layer structures, wherein one of said plurality of electrically conductive layer structures is provided on one main surface of said at least one electrically insulating layer structure and a further one of said plurality of electrically conductive layer structures is provided on an opposing further main surface of said at least one electrically insulating layer structure, forming a through hole in the stack, forming at least one plating layer on at least part of both opposing main surfaces of the stack and on a lateral wall of the stack, forming an axial annular protrusion at one extremity of the through hole, and forming a radial annular protrusion at the lateral wall of the stack.

In the context of the present application, the term "electronic board" may particularly denote any support structure with electric functionality. For example, the electronic board may be a printed circuit board (PCB) or the like. A PCB may be a simple layer stack and does not necessarily need to carry any component. However, the electronic board may also be a component carrier. More generally, the electronic board or PCB or the like may also be an interposer or an IC (integrated circuit) substrate. The electronic board may or may not be capable of accommodating one or more components thereon and/or therein for providing mechanical support and/or electrical connectivity and/or thermal connectivity. In other words, an electronic board may be configured as a mechanical and/or electronic and/or thermal board, for instance but not necessarily also functioning as a carrier for components. An electronic board may comprise a laminated stack, such as a laminated layer stack. In particular, an electronic board may be one of a printed circuit board, an organic interposer, and an IC (integrated circuit) substrate. An electronic board may also be a hybrid board combining different ones of the above mentioned types of electronic boards. An electronic board may be flat or plate-shaped.

In the context of the present application, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive structures and at least one electrically insulating structure.

In the context of the present application, the term "layer structure" may particularly denote a continuous layer, a patterned layer or a plurality of nonconsecutive islands within a common plane, and it may perform the function of electrical conductivity and/or electrical insulation. A layer structure may also comprise an interconnection structure which protrudes from a planar surface of the layer structure.

In the context of the present application, the term "through hole" may particularly denote a hollow volume extending a complete path between two opposing main surfaces of the stack. For example, the through hole may be a single vertical through hole or a single slanted through hole. The through hole may also be composed of a plurality of connected subsections. For instance, the through hole may have a section with vertical sidewalls, may have a section which is tapering, or may have a section with an hourglass shape (i.e. a section which may be formed by two connected subsections tapering in opposite directions). The through hole may be filled with a paste material, in particular comprising an electrically insulating material. However, the through hole may also be empty or void. The through hole extending through the stack may be a through hole extending through the entire electronic board or may form part of a blind hole of the electronic board. The axial and/or radial annular protrusion may be also formed at such a blind hole.

In the context of the present application, the term "conductive material laterally delimiting a through hole" may particularly denote electrically conductive and/or thermally conductive material forming at least part of sidewalls as lateral boundary of the through hole. For instance, at least part of said conductive material may be plated material of a plating layer and/or at least part of said conductive material may be material of a layer structure of the stack, in particular of an electrically conductive layer structure of the stack.

In the context of the present application, the term "plating layer" may particularly denote a structure, in particular a thin-film structure, which may be or which is actually formed by plating. In particular, a plating layer may be formed by electroless plating (for instance by sputtering) and/or electroplating (for example by galvanic plating). A plating layer may be composed of a single homogeneous layer formed by plating, or by a stack of plated sub-layers.

In the context of the present application, the term "axial annular protrusion" may particularly denote a physical structure arranged at and/or around an extremity of the through hole and extending at least partially along an axial direction corresponding to an axis of the through hole. Preferably, the axial direction may be parallel to the stack thickness direction. In particular, such an axial annular protrusion may protrude vertically beyond a surrounding stack portion upwardly or downwardly. An axial annular protrusion may optionally also be integrally formed with a radial annular protrusion, or may be arranged apart from such a radial annular protrusion.

In the context of the present application, the term "radial annular protrusion" may particularly denote a physical structure extending from a sidewall of the through hole inwardly and at least partially perpendicular or angled with respect to an axial direction corresponding to an axis of the through hole. A radial annular protrusion may optionally also be integrally formed with an axial annular protrusion, or may be arranged apart from such an axial annular protrusion. Preferably, the direction of the radial annular protrusion may be parallel to the main extension direction of the electronic board and/or the stack.

In the context of the present application, the term "extremity of through hole" may particularly denote one of two opposing end regions or ends of the through hole. For example, an extremity of the through hole may connect the through hole with a surrounding of the stack or of the electronic board.

In the context of the present application, the term "main surface" of a body may particularly denote one of two largest opposing surfaces of the body or outermost opposing surfaces of the body. The main surfaces may be connected by circumferential side walls. The thickness of a body, such as a stack or a layer structure, may be defined by the distance between the two opposing main surfaces.

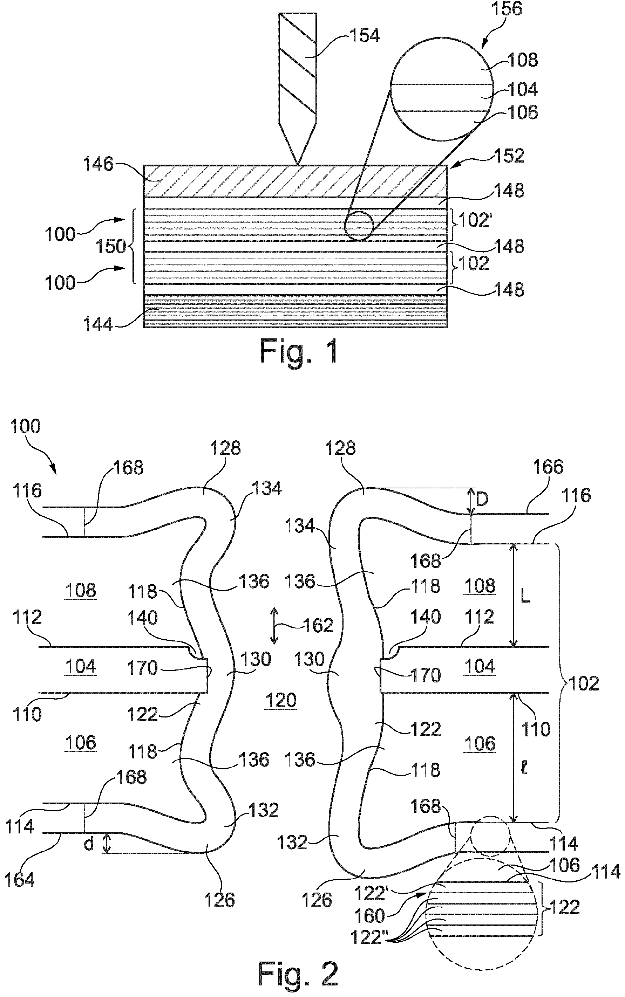

According to an exemplary embodiment of the invention, an electronic board (such as a PCB or the like) comprises a (preferably rolled or laminated) layer stack having an electrically insulating layer structure sandwiched between electrically conductive layer structures. A through hole extends through the stack and may have an at least partially sidewise coverage of conductive material. One or more plating layers at least partially cover at least a part of the two opposing main surfaces, preferably the entire two opposing main surfaces, of the stack and at least a part of a sidewall, preferably the entire sidewall, of the stack as a lateral boundary of at least part of the through hole. Furthermore, one or more axial annular protrusions are formed at one or both axial ends of the through hole. In addition, one or more radial annular protrusions extend from a sidewall of the stack inwardly. Such a configuration (one embodiment thereof is shown in Figure 2) may be a fingerprint of the formation of the through hole by mechanically drilling, in particular making use of a sandwiched configuration as shown for example in Figure 1. Such an electronic board and a corresponding manufacturing method may correspond to a characteristic through hole shape and electronic board boundary with reduced burr during mechanical drilling in particular when using relatively soft metallic layers (such as rolled copper foils) for the stack. Advantageously, one or more separation foils may separate the stack from a surrounding during such a mechanical drilling process for obtaining the described geometry with reduced burrs.

### Detailed Description of Exemplary Embodiments

In the following, further exemplary embodiments of the electronic board and the method will be explained.

In an embodiment, the axial annular protrusion is defined at least partially by said one electrically conductive layer structure and/or by said further one electrically conductive layer structure and/or by the at least one plating layer. Additionally or alternatively, the radial annular protrusion is defined at least partially by said one electrically conductive layer structure and/or by said further one electrically conductive layer structure and/or by the at least one plating layer. Descriptively speaking, the material composition of the stack may be modified by the mechanical drilling process which may form moderate vertical or axial protrusions at a top side and/or at a bottom side. Said protrusions may then be covered by the at least one plating layer so as to result in the described geometry and corresponding material composition. Similar phenomena may occur in an interior of the through holes for forming one or more radial annular protrusions based on surrounding stack material. The (plurality of) axial annular protrusion(s) and/or the (plurality of) radial annular protrusion(s) may form a pattern on the exposed surface of the electronic board, which may simplify the handling and/or gripping of the electronic board for a human and/or mechanical operator, since the axial annular protrusion and/or the radial annular protrusion may be configured as a friction-mediating aid.

In an embodiment, the electronic board has only a single axial annular protrusion. This may be achieved by treating the stack during the mechanical drilling process so that formation of a protrusion at one of the two main surfaces is prevented or strongly suppressed. Moreover, it may also be possible to subject only one main surface of the stack to a planarizing process post drilling, such as grinding.

In another embodiment, the electronic board has a respective axial annular protrusion at each of both opposing extremities of the through hole. In particular, two protrusions with different shapes and/or extensions may be formed. When mechanically drilling a stack comprising thick and/or soft metallic sheets, a re-arrangement of metallic material may occur leading to axial annular protrusions at both sides which may have a different appearance.

In an embodiment, at least one extension of the protrusions is substantially constant in a cross sectional view. In particular, the axial annular protrusion and/or the radial annular protrusion may have substantially constant cross-sections along a circumference of the through hole. Alternatively, the axial annular protrusion and/or the radial annular protrusion has varying cross-sections along a circumference of the through hole. Use of the described method may simplify the manufacturing of an electronic board having one or more axial annular protrusions and/or one or more radial annular protrusions having substantially constant cross-sections along a circumference of the through hole in an effective and simple manner. Preferably the contact cross-sections along a circumference of the through hole may have a high symmetry, for example a mirror-plane, which enables to provide plating layers having an accurate plating layer thickness, since the electric field creates symmetric electric field lines to the associated through hole.

In an embodiment, the electronic board comprises a plurality of through holes in the stack, wherein the at least one plating layer is provided on a lateral wall of the stack delimiting each of the through holes, and each through hole having a respective axial annular protrusion provided at one extremity of the respective through hole and having a respective radial annular protrusion provided at the lateral wall of the stack delimiting the respective through hole. When processing electronic boards on panel level or on board level, a large plurality of mechanically drilled through holes may be formed. For instance, an electronic board may comprise at least 10, in particular at least 100 through holes formed as described herein. Thus, the described manufacturing architecture is properly compatible with the mass production of electronic boards, such as PCBs or the like which may involve the formation of a huge plurality of through holes.

In an embodiment, the at least one plating layer, the respective axial annular protrusions and/or the respective radial annular protrusions has or have a different thickness distribution for different ones of the through holes. For instance, it may be possible that different through holes are drilled with different parameters, such as different drill bit diameters and/or with different rotation speed.

In an embodiment, the respective axial annular protrusions form separated protruding islands at, in particular around, different ones of the through holes. Such an island may be a protruded area with respect to a further area, in particular with respect to a surrounding area of the respective island. The axial protrusion may interact with the area of the planar main surface of the layer/stack. Such an axial annular protrusion may form a connection pad and thus may be used to connect a component and/or another electronic board to the electronic board. For example, such an island may be formed by an axial annular protrusion formed partially by material of at least one plating layer being formed only on part of opposing main surfaces of the electronic board.

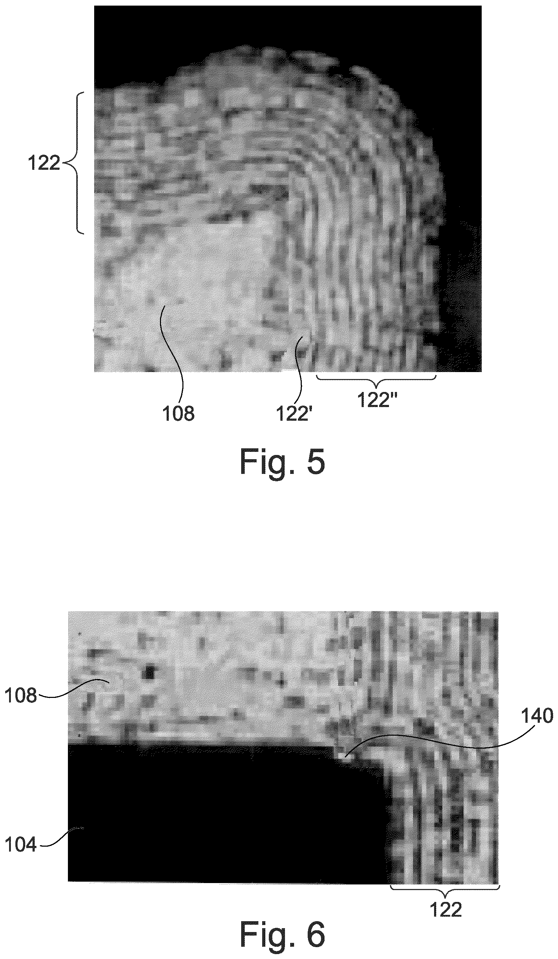

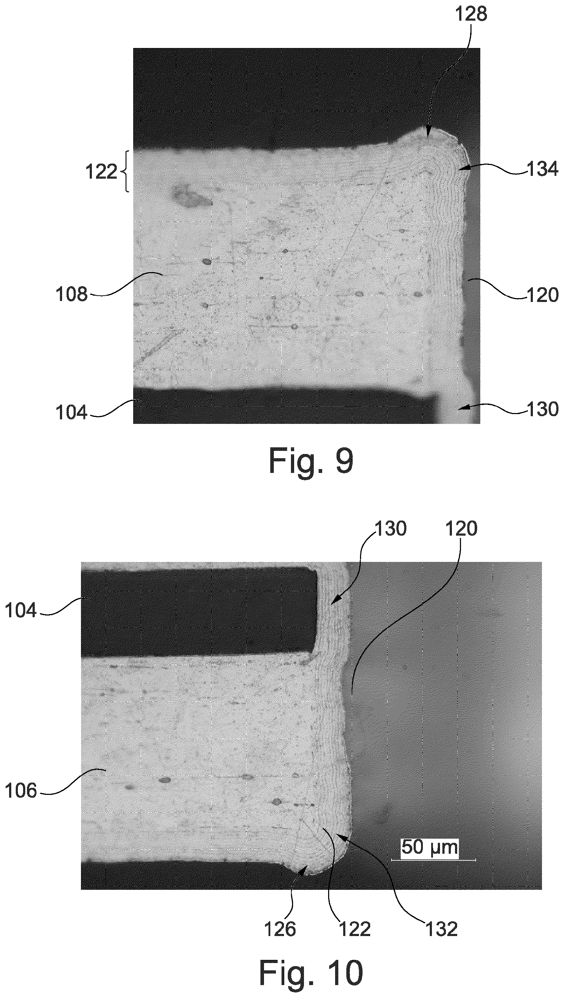

In an embodiment, the axial annular protrusion extends from the lateral wall of the stack. In particular, the axial annular protrusion may extend partially along the axial direction of the through hole but may also extend partially laterally into the through hole. This may bring the advantage of increasing the mechanical integrity of the axial annular protrusion since the material forming the axial annular protrusion, in particular the plating layers, changes the elongation direction from axial to radial and vice versa. In other words, the layers may be bent over the edge thereby enhancing the mechanical stability (see for instance Figure 5 or Figure 9).

In an embodiment, the radial annular protrusion forms a bottleneck of the through hole so that at least a portion of the through hole widens at one or both of said one electrically conductive layer structure and said further one electrically conductive layer structure. Hence, the radial annular protrusion may form a local structural constriction or narrow section of the through hole. This may be used to mechanically fix a connection body, for example a pin.

In an embodiment, the radial annular protrusion is arranged at a height level of the stack corresponding to said electrically insulating layer structure. In terms of the manufacturing process, the mechanical drilling process for forming the through hole may rearrange material of the stack due to the mechanical and thermal impact during mechanically drilling. This may lead to an axially central narrow neck portion being at least partially aligned in a vertical direction with the electrically insulating layer structure. Additionally or alternatively, the position of the radial annular protrusion in terms of a height level may be a result of applied plating (in particular electroplating) parameters. For example, the electric field may be different at a height level of the stack where the electrically insulating layer is located compared to the height level of the stack where the electrically conductive layer is located, and thus is may influence the material deposition of electrically conductive material, for example copper.

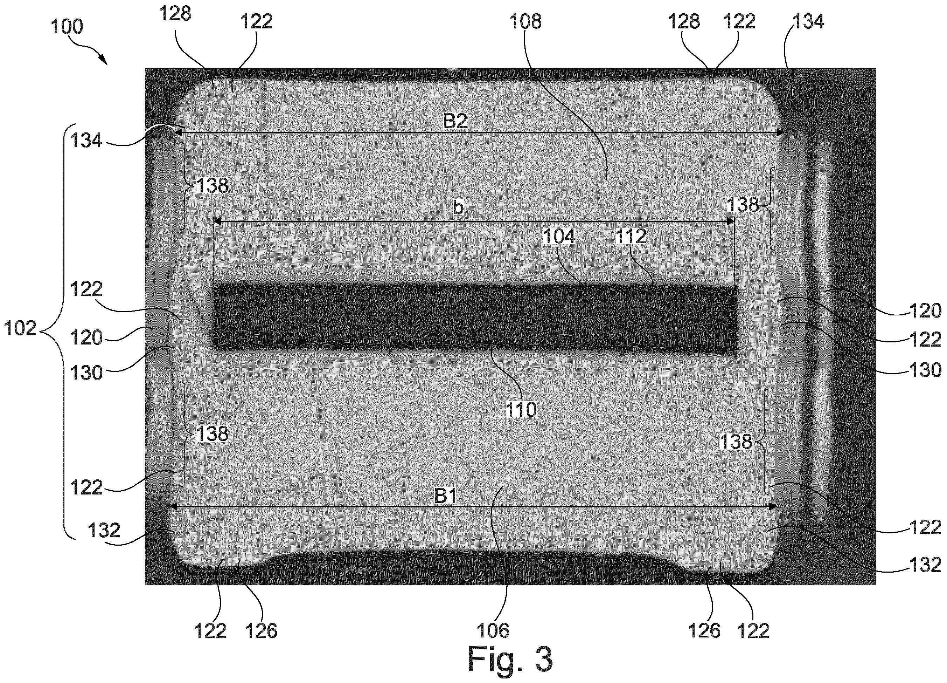

In an embodiment, the through hole has an inner diameter increasing in an axial direction from said electrically insulating layer structure towards an axial middle portion of one or both of said one electrically conductive layer structure and said further one electrically conductive layer structure and decreasing from said axial middle portion in an axial direction further away from said electrically insulating layer structure. Descriptively speaking, the obtained geometry may be denoted as a drum shape. An example is shown in Figure 3. This shape may give a higher mechanical stability to the electronic board and thus may prevent the electronic board from warping.

In an embodiment, said inner diameter (of the through hole located) at (a height level of) said electrically insulating layer structure is different from said inner diameter at an exterior main surface of one or both of said one electrically conductive layer structure and said further one electrically conductive layer structure. A course of the inner diameter along the extension of the through hole may be homogeneous or inhomogeneous. This may give a higher flexibility of designing the stack and/or the electronic board compared to an electronic board having a through hole with laterally straight walls.

In an embodiment, a section of a lateral wall delimiting the through hole and extending between the axial annular protrusion and the radial annular protrusion has a straight shape. In particular, a circular cylindrical section of the through hole may be formed between a central radial annular protrusion and exterior annular protrusions of axial and/or radial type.

In an embodiment, the at least one plating layer comprises a plurality of stacked plating layers. Hence, the at least one plating layer may be composed of multiple sub-layers each corresponding to a respective plating stage.

In an embodiment, an innermost of the stacked plating layers is a seed layer in contact with said electrically insulating layer structure, and in contact with one or both of said one electrically conductive layer structure and said further one electrically conductive layer structure. Such a seed layer may be formed by electroless plating (for instance sputtering or a chemical deposition process) and may thus also cover non-metallic material of the electrically insulating layer structure. The electrically conductive seed layer may form a basis on which one or more further electrically conductive plating layers may be formed, in particular by electroplating (such as galvanic plating).

In an embodiment, the seed layer and/or at least one further plating layer thereon has a substantially constant thickness, in particular with a deviation of less than 10% with respect to a largest thickness of a respective one of the seed layer and/or the at least one further plating layer, along an entire axial extension of the through hole. Additionally or alternatively, the seed layer and/or at least one further plating layer thereon has a substantially constant thickness, in particular with a deviation of less than 10% with respect to a largest thickness of a respective one of the seed layer and/or the at least one further plating layer, along an entire circumference of the through hole. Thus, the individual plating layers may be of homogeneous or substantially homogeneous thickness in an axial and/or radial direction.

In an embodiment, the at least one plating layer comprises a plurality of further plating layers on said seed layer. Said further plating layers may be formed by a plurality of subsequently executed plating stages, in particular galvanic plating stages. Preferably, the amount of layers of the plurality of plating layers and the amount of layers of the plurality of further plating layers may be the same.

In an embodiment, the at least one plating layer comprises a plurality of plating layers, wherein a constant or an average thickness of each of said plating layers deviates by less than 25% from a constant or an average thickness of each other of said plating layers. Hence, different plating layers can differ from each other concerning thickness only marginally. This may lead to a high structural integrity of the electronic board.

In an embodiment, the at least one plating layer comprises a plurality of plating layers, wherein an outermost of said plating layers comprises a material being different from another material of one or more inner ones of said plating layers. For instance, said material comprises silver and/or said other material comprises copper. Thus, the outermost material can be made of another material than the material of the other plating layers. This may allow to embody the outermost plating layer as a surface finish material. For example, said outermost plating layer may be made of a corrosion resistant material or an oxidation resistant material, such as a silver. In contrast to this, the remaining one or more inner plating layers may be made of a material being specifically adapted for another function, for instance for allowing low ohmic current or signal transmission and/or providing high thermal conductivity (for instance for promoting heat dissipation). In view of this, the one or more remaining inner plating layers may be made of copper. The use of different materials with different plating layers may allow to refine the functionality of the electronic board.

In an embodiment, the at least one plating layer, in particular comprising a seed layer and at least one further plating layer thereon, forms at least part of the axial annular protrusion and/or of the radial annular protrusion. However, it may also be possible to selectively remove a portion of the respective protrusion including removing a portion of the at least one plating layer, for instance by grinding and/or etching. Additionally or alternatively, the at least one plating layer may have protective properties, for example resistance against the environment, in particular against oxidation and/or moisture. In an example, the at least one plating layer may comprise copper and/or nickel and/or silver and/or gold. This may protect the through hole from decomposition and may ensure a reliable structure of the though hole over a long period of time, for example longer than 3 years.

In an embodiment, the axial annular protrusion and the radial annular protrusion are radially and axially distinct from each other. Alternatively, the axial annular protrusion and the radial annular protrusion are integrally formed. For example, Figure 2 and Figure 3 show an embodiment in which a central radial annular protrusion is distinct from other protrusions. Said examples also shows that at external extremities of the through hole, an integrally formed combined axial and radial protrusion may be provided.

In an embodiment, said electrically insulating layer structure has, at a circumference thereof extending around the through hole, an irregularity with respect to a respective planar main surface of said electrically insulating layer structure. Such an irregularity may be a fingerprint of the formation of the through hole by mechanically drilling, which may also impact a portion of the electrically insulating layer structure being exposed by the mechanical drilling process.

In an embodiment, said irregularity of said electrically insulating layer structure comprises at least one of a circumferential groove, a circumferential thickness variation, and/or a groove and peak structure facing the through hole. Other types of irregularities may be formed as well.

In an embodiment, a part of said at least one plating layer at least partially fills said irregularity of said electrically insulating layer structure. This may be the consequence of the fact that the at least one plating layer may be formed after the mechanical drilling and may thus also at least partially fill an exposed irregularity of the electrically insulating layer structure.

In an embodiment, said electrically insulating layer structure has a diameter smaller than a diameter of said one electrically conductive layer structure, including said at least one plating layer, and/or smaller than a diameter of said further one electrically conductive layer structure, including said at least one plating layer. Such a configuration is shown, for instance, in Figure 3. This may bring the advantage of ensuring a reliable electrical connection between the two extremities of the through hole, since this design enables to provide an electrically conductive layer structure covering the sidewalls of the through hole without totally filling the through hole and having substantially straight sidewall-portions.

In an embodiment, a diameter of said one electrically conductive layer structure is different from a diameter of said further one electrically conductive layer structure. The diameters may alternatively also be the same.

In an embodiment, a part of said at least one plating layer is arranged directly on said electrically insulating layer structure, in particular on a lateral surface and/or on a main surface of said electrically insulating layer structure. Such a plating layer may be formed at least partially by electroless plating, for instance by sputtering, which may also allow to cover a dielectric surface.

In an embodiment, said electrically insulating layer structure is made of a plastic material, in particular polyimide. Copper layers may be rolled on such a plastic layer for forming a stack which may then be subjected to mechanical drilling. This may bring the advantage of imparting flexible behavior to the electronic board. Thus, after finalization of manufacturing the electronic board, it can be bent into a preferred shape.

In an embodiment, said one electrically conductive layer structure and/or said further one electrically conductive layer structure has a thickness of at least 80 µm, in particular of at least 100 µm. With such relatively thick electrically conductive layer structures, in particular copper sheets, stacks may be formed by rolling on said metal sheets on an electrically insulating layer structure, such as a plastic foil.

In an embodiment, the electronic board comprises a further axial annular protrusion provided at an opposing other extremity of the through hole. The two opposing axial annular protrusions may be of different characteristics, in particular may protrude over different spatial ranges, as a consequence of the mechanical drilling process having a different impact on the top and on the bottom main surface of the stack.

In an embodiment, the electronic board comprises at least one further radial annular protrusion provided at one extremity or at both opposing extremities of the through hole. In particular (see for instance Figure 2), one radial annular protrusion may be formed in a central portion of the through hole and two further radial annular protrusions may be formed on two opposing extremities or ends of the through hole.

In an embodiment, said axial annular protrusion protrudes vertically by less than 30 µm, in particular by less than 20 µm, preferably by less than 7 µm. In particular when applying a manufacturing process involving mechanically drilling using separation foils as described herein, significantly lower axial annular protrusions may be obtained as compared with conventional burrs. For instance, an axial annular protrusion with a height of less than 30 µm may be obtained at a back side of the stack with reference to the drilling process. For example, an axial annular protrusion with a height of less than 20 µm may be obtained at a front side of the stack with reference to the drilling process. When executing in addition a planarizing process, for instance a grinding process such as chemical mechanical polishing (CMP), an axial annular protrusion with a height of less than 7 µm may be obtained, which complies even with very strict specifications.

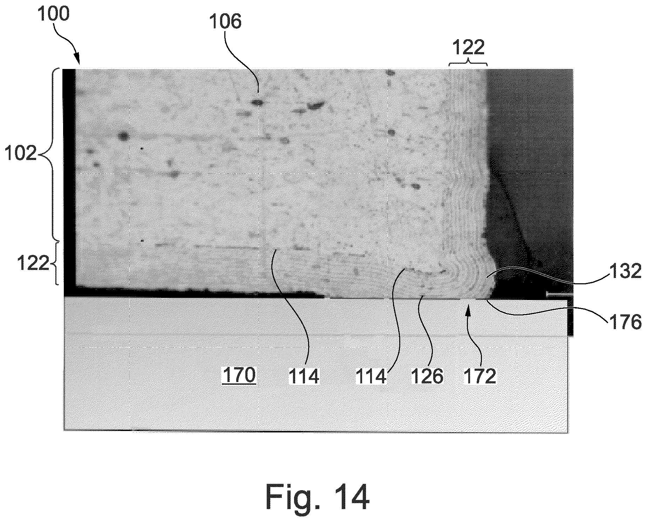

In an embodiment, the at least one plating layer comprises a plurality of plating layers, wherein at a circumference of the through hole at least one of the plurality of plating layers does not extend or discontinuously extends at at least one of the main surfaces of the stack. When selectively grinding an axial annular protrusion on one or both of the two opposing main surfaces of the electronic board, the outermost one or more plating layers may be removed only which may lead to a discontinuous plating layers configuration at a top side and/or a bottom side of the electronic board (compare Figure 14). This may expose a dedicated layer of the plurality of plating layers at a preferred location on the exposed main surface of the electronic board, which can be selectively used for a purpose, for example a soldering or sintering process.

In an embodiment, one edge of one of the plurality of electrically conductive layer structures covered by the at least one plating layer is sharp. It may also be that an edge of each respective of the electrically conductive layer structures covered by the at least one plating layer is sharp. Again, this may be the consequence of a planarizing grinding process, as described beforehand and as shown in Figure 14.

In an embodiment, the method comprises forming the at least one plating layer, preferably a plurality of plating layers, by electroplating and/or electroless plating.

In an embodiment, the method comprises forming the through hole in the stack by mechanically drilling. Due to the mechanical drilling process, the involved mechanical drill bit may push the material in close proximity to the through hole in the direction parallel to the drill bit movement and thus may create the axial annular protrusion and/or the radial annular protrusion.

In an embodiment, the method comprises forming the through hole in the stack while the stack is arranged between a bottom protection structure and a top protection structure. The bottom protection structure and the top protection structure may promote a configuration in which the stack in between does not experience excessive burr formation. Additionally or alternatively, the bottom protection structure and/or the top protection structure may prevent the stack from transversely shifting during the process of the formation of the through hole, in particular during mechanical drilling.

In an embodiment, the method comprises using a board as the bottom protection structure and/or a metal foil, in particular an aluminum foil, as the top protection structure. Such a bottom protection structure may provide strong mechanical support. Such a top protection structure may prevent overheating thanks to the high thermal conductivity of metals.

In an embodiment, the method comprises arranging a release foil between the stack and the bottom protection structure and/or between the stack and the top protection structure during forming the through hole. Such a release foil (for instance of Teflon or with a waxy surface) may be poorly adhesive so that, after the through hole drilling, the stack may be simply detached from the release foil(s) without an undesired formation of a connection of the stack with other material.

In an embodiment, the method comprises forming the through hole in the stack and simultaneously forming a further through hole in a further stack being stacked with said stack during forming said through holes. Advantageously, a plurality of stacks may be stacked for a common drilling of through holes. This may increase the throughput.

In an embodiment, the method comprises arranging a release foil between the stack and the further stack during forming the through holes. Such a release foil (for instance of Teflon or with a waxy surface) may be poorly adhesive so that, after the through hole drilling, the stack may be simply detached from the other stack with the release foil in between without an undesired formation of a connection of the stack with the other stack. It may also be possible to stack three or more stacks and to form through holes by mechanically drilling simultaneously for all these stacks.

In an embodiment, the method comprises grinding one main surface or grinding both opposing main surfaces, in particular simultaneously, of the electronic board or a preform thereof for reducing a height of said axial annular protrusion. For instance, such a grinding may be done by chemical mechanical polishing (CMP). Alternatively, thanks to the described manufacturing process, a grinding stage may also be omitted since the manufacturing process will automatically lead to only small burrs.

In an embodiment, the electronic board comprises a stack of at least one electrically insulating layer structure and at least one electrically conductive layer structure. For example, the electronic board may be a laminate of the mentioned electrically insulating layer structure(s) and electrically conductive layer structure(s), in particular formed by applying mechanical pressure and/or thermal energy. The mentioned stack may provide a plate-shaped electronic board capable of providing a large mounting surface for components and being nevertheless very thin and compact.

In an embodiment, the electronic board is shaped as a plate. This contributes to the compact design, wherein the electronic board nevertheless provides a large basis for mounting components thereon. In particular a naked die as example for an electronic component can be surface mounted on a thin plate such as a printed circuit board.

In an embodiment, the electronic board is configured as one of the group consisting of a printed circuit board, a substrate (in particular an IC substrate), and an interposer.

In the context of the present application, the term "printed circuit board" (PCB) may particularly denote a plate-shaped electronic board which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small electronic board, in particular an IC substrate. An IC substrate may be, in relation to a PCB, a comparably small electronic board onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as electronic board comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the electronic board as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component, which may be surface mounted on and/or embedded in the electronic board, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the electronic board. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further electronic board, for example in a board-in-board configuration. The component may be surface mounted on the electronic board. Moreover, also other components, in particular those which generate and emit electromagnetic radiation and/or are sensitive with regard to electromagnetic radiation propagating from an environment, may be used as component.

In an embodiment, the electronic board is a laminate-type electronic board. In such an embodiment, the electronic board is a compound of multiple layer structures which are stacked and connected together by applying a pressing force and/or heat.

After processing interior layer structures of the electronic board, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or electronic board.

In particular, an electrically insulating solder resist may be applied to one or both opposing main surfaces of the layer stack or electronic board in terms of surface treatment. For instance, it is possible to form such a solder resist on an entire main surface and to subsequently pattern the layer of solder resist so as to expose one or more electrically conductive surface portions which shall be used for electrically coupling the electronic board to an electronic periphery. The surface portions of the electronic board remaining covered with solder resist may be efficiently protected against oxidation or corrosion, in particular surface portions containing copper.

It is also possible to apply a surface finish selectively to exposed electrically conductive surface portions of the electronic board in terms of surface treatment. Such a surface finish may be an electrically conductive cover material on exposed electrically conductive layer structures (such as pads, conductive tracks, etc., in particular comprising or consisting of copper) on a surface of an electronic board. If such exposed electrically conductive layer structures are left unprotected, then the exposed electrically conductive electronic board material (in particular copper) might oxidize, making the electronic board less reliable. A surface finish may then be formed for instance as an interface between a surface mounted component and the electronic board. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickelgold, nickel-palladium, etc.

The aspects defined above and further aspects of the invention are apparent from the examples of embodiment to be described hereinafter and are explained with reference to these examples of embodiment.
Figure 1 illustrates a cross-sectional view of a structure obtained during carrying out a method of manufacturing an electronic board according to an exemplary embodiment of the invention.
Figure 2 illustrates a cross-sectional view of an electronic board according to an exemplary embodiment of the invention.
Figure 3 illustrates a cross-sectional image of an electronic board according to an exemplary embodiment of the invention.
Figure 4 illustrates a cross-sectional image of an electronic board according to an exemplary embodiment of the invention.
Figures 5 to 12 illustrate details of the image of the electronic board according to Figure 4.
Figure 13 illustrates a cross-sectional image of an electronic board according to an exemplary embodiment of the invention.
Figure 14 illustrates a cross-sectional image of an electronic board according to an exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

For certain special applications in the framework of the manufacture of electronic boards (such as a PCB or the like), rolled copper foils (so-called RA copper, i.e. "rolled annealed copper") are used and are subjected to mechanical drilling during the manufacturing process for through hole formation. Due to the specific properties of such rolled copper foils, it has been conventionally only possible to process packs of one stack only at a time. When trying to execute the manufacturing method with a stacked configuration of two or more stacks, the sheets tended to stick together and/or pronounced surface indentations and burrs were created. Under undesired circumstances, the stack may show a behavior in terms of sticking or gluing or kind of welding to cover sheets. With a separating or release foil in between, highly satisfying result can be achieved. Alternatively, plated copper foils may be implemented.

According to an exemplary embodiment of the invention, a preferably PCB-like electronic board is provided with a stack (preferably formed by lamination, i.e. the application of heat and/or pressure for connecting different layer structures with each other, or by rolling) comprising at least one electrically insulating layer structure located between two or more electrically conductive layer structures. During a manufacturing process, one or preferably a large plurality (for instance at least 10 or at least 1000) of through holes are formed in the stack, preferably by mechanically drilling using a rotating drill bit. Sidewalls of the stack may be coated partially or entirely by conductive material, preferably electrically conductive material. At least one plating layer covers, partially or entirely, main surfaces of the stack and sidewalls of the through hole. In addition, at least one axial annular protrusion extends at at least one extremity delimiting the through hole in an axial direction. Furthermore, at least one radial annular protrusion extends inwardly from a lateral wall of the through hole, preferably in an interior thereof and optionally axially between two opposing axial annular protrusions at the ends of the through hole. The described geometry (see Figure 2 showing an example) may result from through hole forming by mechanically drilling, for instance on the basis of the arrangement of Figure 1. An electronic board manufactured in such a way may advantageously show a reduced burr compared with conventional approaches obtained by mechanical drilling. Thus, manufacture of electronic boards on an industrial scale and with an increased yield may be made possible.

In particular the mechanical drilling of a stacked plurality of layer stacks with separation foils in between has turned out as an efficient manufacturing method leading to a high quality of obtained electronic boards.

Advantages obtained by such embodiments include a reduction of burr created by mechanical drilling due to the electrically conductive layer structures (in particular with a burr height of not more than 30 µm using RA copper foils thicker than 100 µm, more particularly with a burr height in the range from 1 µm to 30 µm). Alternatively, the burr height may be in the range from 1% to 30% of the thickness of the electrically conductive layer structure, in which the through hole is formed. Such a manufacturing method may also lead to an increase of efficiency by increasing the stack height, which may result in reduced manufacturing time and consequently a reduced manufacturing effort. Moreover, exemplary embodiments may allow to increase the surface quality of the obtained electronic boards and may allow to reduce surface indentations. Advantageously, no residues of the separating foil or film remain at the readily manufactured electronic boards. Beneficially, such a manufacturing architecture may be advantageously applied in particular to thin laminates with rolled copper foil (such as RA copper). By making it possible to mechanically drill a plurality of layer stacks simultaneously by stacking them during mechanically drilling with separation foils in between may significantly increase the manufacturing efficiency by using doubled stack height or even a stack height involving three or more stacks being mechanically drilled simultaneously for forming through holes.

In some embodiments, different burr sizes may be obtained on opposed sides of a PCB-type electronic board. For optionally planarizing electronic boards for further reducing burr height, chemical mechanical polishing (CMP) may be carried out for obtaining flattened areas. However, in another embodiment, a separate planarizing stage, for instance by grinding, more specifically using CMP, may be omitted due to the already significantly reduced burr height obtained by exemplary embodiments.

According to exemplary embodiments, an electronic board is provided which comprises a stack comprising at least one electrically insulating layer structure and a plurality of electrically conductive layer structures. One of said plurality of electrically conductive layer structures may be provided on one surface of said at least one electrically insulating layer structure, and a further one of said plurality of electrically conductive layer structures may be provided on the opposed surface of said at least one electrically insulating layer structure. Said electronic board may further comprise a through hole laterally delimited by a conductive material, and at least one plating layer provided on the main surfaces of the stack and the lateral wall of the through hole. An axial annular protrusion may be provided at at least one extremity of the through hole (which may be defined by the electrically conductive layer structure and/or the plated layer). Furthermore, a radial annular protrusion may be provided at the lateral wall of the through hole.

Preferably, said axial annular protrusion may be arranged on one surface only (or on both). In an embodiment, two protrusions may be formed, one in each of the opposed ones of the main surfaces. In particular, two protrusions with different shapes and/or extensions may be formed. In an embodiment, the protrusion has a constant cross section along its circumference. Alternatively, the axial annular protrusion may have a variable cross section along its circumference. For example, a plurality of through holes may be provided. In particular, different stack thickness distributions may be formed between two through holes, of at least one of the conductive layers. Advantageously, it may be possible to provide one or more protruding islands at one of the main surfaces of the layers around the through hole. For example, the protrusions may axially extend from at least one main surface and/or radially extend from the lateral wall of the through hole.

Now referring to the radial annular protrusion, an enlargement of the through hole may be formed at one or at both of the conductive layer structures in contact with the at least one insulating layer structure. Furthermore, it may be possible to define a drum shape (in particular having a diameter increasing from the electrically insulating layer structure toward the middle of the one or the further one of the plurality of electrically conductive layer structures, and a decrease may be formed from the middle to the surface away from the electrically insulating layer structure). In an embodiment, the diameter of the through hole at the insulating structure may be different (in particular smaller) that the diameters at the external surfaces of the stack. For instance, the protrusion has substantially the same cross section along its circumference. Alternatively, the radial annular protrusion has a varying cross section along its circumference. For example, the lateral wall of the through hole extending between the axial and the radial protrusions has a cylindrical (or straight) shape. In an embodiment, a seed layer is provided in contact with the at least one electrically insulating layer structure. For example, a seed layer is provided in contact with the at least one electrically insulating layer structure and one of the two conductive layer structures. In an embodiment, one or both of the seed layer and the plated layer have this protrusion. For example, the seed layer and the plated layer have substantially the same thickness along the through hole extension. In an embodiment, one or each one of the plated layers has or have the same thickness along the circumference of the through hole (i.e. at the same vertical level), in particular with a deviation of less than 10%. For example, the plated layers at the lateral wall(s) of the through hole have the same thickness, in particular with a deviation of less than 25%. In an embodiment, the sum of the thicknesses of the plated layers and/or seed layers may be smaller than the thickness of at least one electrically conductive layer structure (related to stack thickness direction). In an embodiment, several plated layers may be provided stacked from the seed layer. For instance, the protrusions are not radially or frontally connected one to each other. For example, the outermost layer is made of a material different from the other (conductive or plated) layers, in particular Ag (for example on Cu).

What concerns the (in particular central) insulating layer structure, there may be an irregularity with respect to the respective planar main surface(s) at the circumference around the through hole. For instance, a (preferably circumferential) groove may be formed. In particular, there may be a thickness variation towards the circumference. For instance, a groove and a peak may be formed at the hole of the insulating structure. In an embodiment, the diameter in the insulating layer structure is smaller than the diameter of the one and the further one of electrically conductive layer structures. For example, the diameter of the one of the electrically conductive layer structures is different from the diameter of the further one of the electrically conductive layer structures. In an embodiment, the plated layer at least partially extends on the main surfaces of the insulating layer. There may be an at least partial filling, preferably on the side of the (preferably circumferential) groove. On the side of the (preferably circumferential) groove, the conductive layer may have a diameter greater than that of the opposed conductive layer.

Now referring to an optional grinding process for further reducing a burr height of the electronic board, such grinding can be executed on one side or both sides of the electronic board. In particular, at least one of the layers at the circumference of the through hole does not extend or discontinuously extends at one of the main surfaces of the stack. For example, the external edge of the through hole is rounded along the thickness direction. For instance, one edge of one of the conductive layer is sharped. In an embodiment, the edge of the respective conductive layer is sharped.

For example, grinding may be carried out after plating, because the electronic board or a panel comprising a plurality of electronic boards may then be more stable. Grinding may be carried out for deburring. For example, grinding may comprise treating the electronic board with ceramic brushes, so that a purely mechanical grinding process may be possible. It is also possible that grinding is accompanied by a chemical agent, such as a slurry. Grinding may be carried out on both opposing sides of the electronic board simultaneously.

The manufacturing process can be executed on an already separated or individual electronic board. Alternatively, the manufacturing process may be carried out on a preform of electronic boards, such as a panel, comprising a plurality of still integrally connected electronic boards, i.e. on panel level. Such a panel may be separated, for instance by routing, into a plurality of individual electronic components at the end of the manufacturing process.

Drilling electronic boards or panels may include forming a plurality of through holes. For example, more than 1000 through holes may be formed per panel. The through holes may be arranged in rows and columns, i.e. in a matrix like pattern.

According to exemplary embodiments, low-burr or even burr-free mechanical drilling of copper sheets may be made possible. More specifically, burrs which may be created at exterior surface portions of a stack during mechanical drilling of copper (in particular rolled copper sheets) may be significantly reduced. Preferably, one or more separation foils be arranged between adjacent panels when a package of stacked panels is mechanically drilled at the same time for forming through holes.

Without usage of separation foils between stacked panels or stacked electronic boards, rolled copper material may interact with a layer above and/or below. Since rolled copper is rather soft, the mechanical drilling process may create a permanent connection of rolled copper material to other material. However, when using a separation foil according to an exemplary embodiment of the invention, the interconnection to other layers or material may be reliably prevented, and furthermore burrs of the copper layer may be reduced. Due to the mechanical drilling process, formed burrs on the top side may be smaller compared to burrs formed on the bottom side. Furthermore, if desired or required, a chemical mechanical polishing (CMP) process can be applied to further reduce burrs in order to fulfill even demanding quality requirements.

Hence, exemplary embodiments of the invention implementing one or more separation foils may enable mechanical drilling of rolled copper without interacting with a backup board, an aluminum entry foil or with other panels or electronic board preforms of a stack (compare Figure 1). Thereby, the throughput may be enlarged, and burrs around a mechanical drilling hole may be maintained within limits allowed by a specification. Relatively soft rolled copper (also denoted as RA copper) may render a mechanical drilling process challenging, wherein the above-described process may allow to create an electronic board with advantageous properties while simultaneously leading to a high throughput. This may even allow to process thick copper layers, for instance with a thickness of more than 80 µm, in particular more than 100 µm, for example 105 µm. A stack of two, three or more electronic boards or panels may be mechanically drilled simultaneously with excellent results.

**Figure 1** illustrates a cross-sectional view of a structure obtained during carrying out a method of manufacturing an electronic board 100, for instance the one shown in Figure 2, according to an exemplary embodiment of the invention.

Figure 1 shows a working stack 152 which may be built up for the formation of through holes by mechanical drilling using one or more rotatable drill bits 154. While only a single drill bit 154 is shown in Figure 1 for forming a single through hole extending through a plurality of stacks 102, 102' simultaneously, a plurality of drill bits may be foreseen and/or drill bits may be moved relatively to a surface of the working stack 152 for forming a plurality of through holes simultaneously and/or subsequently. For instance for processing panels each including a plurality of electronic boards 100 to be processed in common, it may be possible to form at least 100 through holes, in particular at least 1000 through holes per panel. For example, each electronic board 100 may comprise at least 10 through holes, in particular at least 100 through holes.

Again referring to working stack 152 shown in Figure 1, said working stack 152 may comprise a bottom protection structure 144 on the bottom side and a top protection structure 146 on a top side. Between the bottom protection structure 144 and the top protection structure 146, a plurality of stacks 102, 102' may be arranged in a stacked fashion. Each stack 102, 102' may correspond to a panel to be processed or may correspond to a preform of an electronic board 100 to be processed. Advantageously, one or more release foils 148 may be spatially arranged between adjacent constituents of the working stack 152 for separating them from each other during mechanically drilling. In the shown configuration, a release foil 148 may be arranged between the bottom protection structure 144 and the lowermost stack 102. A further release foil 148 may be arranged between the adjacent stacks 102, 102'. Yet another release foil 148 may be arranged between the uppermost stack 102' and the top protection structure 146.

For example, the bottom protection structure 144 may be embodied as a backup board, for instance a printed circuit board or a printed circuit board panel or a dummy structure. The bottom protection structure 144 may be provided for giving mechanical support to the constituents of the working stack 152 during mechanically drilling. Each of the stacks 102, 102' may be embodied as an electronic board or a preform thereof, or as a panel comprising a plurality of integrally connected preforms of electronic boards. Through holes are to be formed in the stacks 102, 102' by mechanically drilling using drill bit(s) 154. While two vertically stacked stacks 102, 102' are shown in Figure 1, it may also be possible to stack three or more than three such stacks on top of each other. The top protection structure 146 may be embodied as a metallic entry foil, for instance made of aluminum. The metallic entry foil has a high thermal conductivity and thereby avoids overheating of the drill bit 154 during mechanical drilling while simultaneously reducing burr formation during drilling.

Particularly advantageous are the spacers in form of the release foils 148. For example, such a release foil 148 may be made of polyimide, polytetrafluoroethylene or another polymer. The release foils 148 are preferably made of a material having poorly adhesive properties so that the individual stacks 102, 102' may be separated from each other and from the protection structures 144, 146 after having formed the drill holes by mechanically drilling. Apart from their function of preventing undesired integral connection (for instance by unintentional welding) of adjacent drilled structures during the mechanical drilling process, the release foils 148 may also have a positive impact on the reduction of burr formation and in particular burr height on the opposing main surfaces of the drilled stacks 102, 102'. Furthermore, the use of such separation or release foils 148 may lead to a very specific shape of the electronic boards 100 and in particular their stacks 102, 102' around the formed drill holes 120 (see Figure 2 or Figure 3).

As shown in a detail 156 in Figure 1, stack 102 (and correspondingly stack 102', not shown) comprises an electrically insulating layer structure 104 arranged between two electrically conductive layer structures 106, 108. For example, the electrically insulating layer structure 104 may comprise resin (such as an epoxy resin), and optionally reinforcing particles (for example glass spheres of glass fibers). However, said electrically insulating layer structure 104 may also be made of a plastic material, in particular polyimide. Alternatively, the stack electrically insulating layer structure 104 may be free from reinforcing particles and/or may be made of a flexible material, for example polyimide or polyisoprene. The electrically conductive layer structures 106, 108 may be copper sheets, in particular made of rolled copper. After having built up the working stack 152 of Figure 1, the manufacturing method proceeds with the simultaneous formation of through holes (see reference sign 120 in Figure 2 Figure 3) in the stacks 102, 102' by mechanically drilling using one or more rotating drill bits 154 while the stacks 102, 102' are arranged stacked between the bottom protection structure 144 and the top protection structure 146 and are spaced with regard to adjacent structures by the release foils 148.

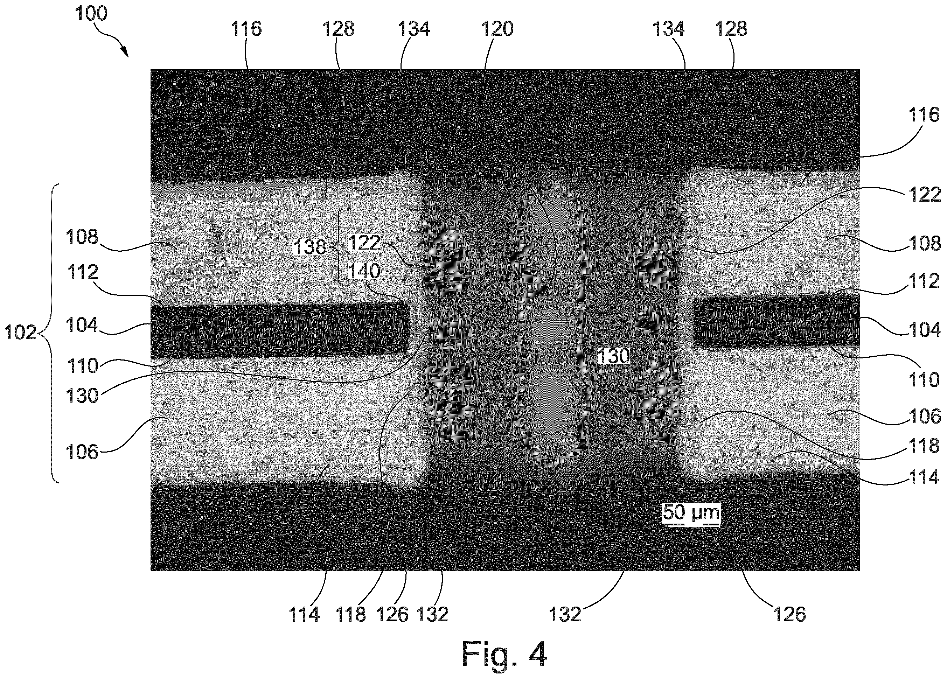

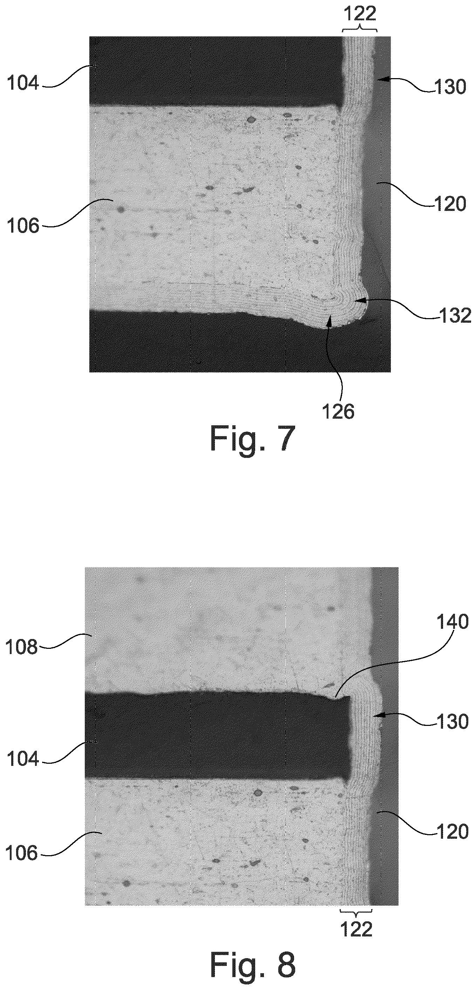

During said drilling process, rounded axial annular protrusions (see Figure 4 or Figure 5) may be formed at the opposing extremities or ends of the through hole 120 in each of the stacks 102, 102'. Alternatively, an edged protrusion (in particular an edged axial annular protrusion) may be created. Furthermore, one or more radial annular protrusions (compare reference signs 130, 132, 134 in Figure 2 or Figure 3) may be formed during mechanically drilling and/or during plating at a lateral wall delimiting the through hole 120. For instance in Figure 2 or Figure 3, the one or more radial annular protrusions 130, 132, 134 may be formed at least partially by plating layers. However, as can be seen for example in Figure 7, a radial annular protrusion can also be created by the drilling process in the electrically conductive layer structure(s) 106 (108), and in plated layers on top of this protrusion which increases the radius of the protrusion and/or renders said protrusion more pronounced.

After the drilling process, the obtained processed working stack 152 may be separated by detaching its constituents from each other. In particular, the processed stacks 102, 102' may be easily separated from the release foils 148 without the risk of unintentional mutual connection of adjacent constituents with each other due to the mechanical drilling process. Moreover, the separation or release foils 148 may be removed from the stacks 102, 102' without residues of the protection or release foils 148 remaining on the stacks 102, 102'.

Thereafter, the manufacturing process of the electronic boards 100 may proceed with the formation of one or more plating layers (see reference sign 122 in Figure 2 and Figure 3) on both opposing main surfaces (see reference signs 114, 116 in Figure 2 and Figure 3) of the respective stack 102, 102' and on a lateral wall 118 of the respective stack 102, 102'. Formation of the plating layers 122 may be done by electroless plating (for instance sputtering and/or a wet-chemical process) followed by electroplating (for instance galvanic plating).

Optionally, the method may then proceed with grinding of one or simultaneously both opposing main surfaces of the electronic boards 100 or the stacks 102, 102' for additionally reducing a height of said axial annular protrusion 126, 128. This grinding may be accomplished for example by chemical mechanical polishing (CMP) and may reduce the height of the axial annular protrusions 126, 128, in particular by also removing material of the plating layers 122 in corresponding regions. In other embodiments, CMP may also be omitted thanks to the already strongly suppressed height of the burrs due to the described manufacturing method. For example, top-sided burrs at the drilled stacks 102, 102' may have a height of less than 20 µm, and bottom-sided burrs at the drilled stacks 102, 102' may have a height of less than 30 µm.

Referring to Figure 2 and Figure 3, an obtained geometry of the described manufacturing method will be explained. While Figure 2 is a schematic cross-sectional view, Figure 3 illustrates an experimentally obtained image of a manufactured electronic board 100.

**Figure 2** illustrates a cross-sectional view of an electronic board 100 according to an exemplary embodiment of the invention. The electronic board 100 may be embodied as a printed circuit board (PCB) or the like. Although only one through hole 120 is shown in Figure 2, the electronic board 100 may comprise a plurality of through holes 120, for instance at least 10 or at least 100 through holes 120.

The electronic board 100 according to Figure 2 comprises a laminated or rolled layer stack 102 comprising a central electrically insulating layer structure 104 sandwiched between two peripheral electrically conductive layer structures 106, 108. Electrically conductive layer structure 106 is formed on a bottom main surface 110 of said electrically insulating layer structure 104. Further electrically conductive layer structure 108 is provided on an opposing upper main surface 112 of said electrically insulating layer structure 104. In the shown embodiment, electrically insulating layer structure 104 may for example be a sheet of resin, prepreg or FR4. However, said electrically insulating layer structure 104 may also be made of a plastic material, in particular polyimide. Any of the electrically conductive layer structures 106, 108 may be a sheet of rolled copper, which may be relatively soft. The electrically conductive layer structures 106, 108 may be relatively thick. For example, said one electrically conductive layer structure 106 may have a thickness I of at least 80 µm. Correspondingly, said other electrically conductive layer structure 108 may have a thickness L of at least 80 µm, in particular of at least 100 µm. Preferably, the two respective electrically conductive layer structures 106, 108 may be similar, or may have a deviation smaller than 10%, in particular smaller than 5%.

A through hole 120, which may be for instance a vertical or substantially vertical through hole, is formed in the stack 102 and extends through the entire stack 102 so as to be open at its upper extremity or end and at its lower extremity or end. The through hole 120 may be formed by mechanical drilling using a rotating drill bit 154 such as the one shown in Figure 1.

The through hole 120 is laterally delimited by electrically and thermally conductive material of plating layers 122, as shown in Figure 2. In an example the electrically and thermally conductive material may have an electrical conductivity higher than 10⁵ S/m (or less). In another example, the electrically and thermally conductive material may have a thermal conductivity higher than 100 W/mK. Said plating layers 122 are provided on both opposing main surfaces 114, 116 of the stack 102 and on a lateral wall 118 of the stack 102.

As shown in a detail 160 of Figure 2, the plating layers 122 are here embodied as a plurality of stacked plating layers 122', 122" of different types. More specifically, an innermost of the stacked plating layers 122', 122" formed on exposed portions of layer structures 104, 106, 108 is a seed layer 122' in direct physical contact with the electrically insulating layer structure 104 and with both electrically conductive layer structures 106, 108.

The seed layer 122' and the further plating layers 122" thereon may have a substantially constant thickness with a deviation of less than 10% with respect to a largest thickness of a respective one of the seed layer 122' and the further plating layers 122" along an entire axial extension of the through hole 120. Moreover, the seed layer 122' and the further plating layers 122" thereon may have a substantially constant thickness with a deviation of less than 10% with respect to a largest thickness of a respective one of the seed layer 122' and the further plating layers 122" along an entire lateral circumference of the through hole 120. A constant or an average thickness of each of said plating layers 122', 122" may deviate by less than 25% from a constant or an average thickness of each other of said plating layers 122', 122". Thus, the plating layers 122', 122" may have homogeneous properties.

An outermost of said plating layers 122', 122" exposed in through hole 120 may comprise a material being different from another material of one or more inner ones of said plating layers 122', 122". For instance, the outermost of said plating layers 122', 122" may comprise silver, whereas all other or inner constituents of the plating layer 122 may comprise copper. Thus, the outermost of said plating layers 122', 122" may be a surface finish which may protect for example against corrosion or oxidation, whereas the inner constituents of the plating layer 122 may be optimized for providing high electrical conductivity. However, other functional adaptations of constituents of the plating layer 122 may be possible. A portion of said plating layers 122 is arranged directly on said electrically insulating layer structure 104. This may be accomplished in particular by electroless plating.

In addition, the electronic board 100 according to Figure 2 comprises mutually opposing axial annular protrusions 126, 128 each provided at a respective one of the opposing upper and lower extremities of the through hole 120. The axial annular protrusions 126, 128 protrude vertically beyond planar upper or lower surface portions 164, 166 of the electronic board 100 by a respective distance d, D. More specifically, axial annular protrusion 126 is located at a bottom end of the through hole 120 and protrudes downwardly with respect to planar surface portion 164 of the electronic board 100 by a vertical distance d which may be not more than 30 µm. Correspondingly, axial annular protrusion 128 is located at a top end of the through hole 120 and protrudes upwardly with respect to planar surface portion 166 of the electronic board 100 by a vertical distance D which may be not more than 20 µm. Nevertheless, the vertical distance d and the vertical distance D may be bigger than 0.5 µm. Thus, rounded burrs with very small vertical extension may be obtained thanks to the manufacturing process described referring to Figure 1.

In addition, electronic board 100 comprises radial annular protrusions 130, 132, 134 protruding inwardly from the lateral wall 118 of the stack 102. Central radial annular protrusion 130 is located in an interior of the through hole 120, in particular at a height level corresponding to electrically insulating layer structure 104. The exterior radial annular protrusions 132, 134 are arranged at the extremities of the through hole 120. More specifically, radial annular protrusion 132 is arranged at the bottom end of the through hole 120 and is integrally formed with the axial annular protrusion 126. Correspondingly, radial annular protrusion 134 is arranged at the top end of the through hole 120 and is integrally formed with the axial annular protrusion 128. The peripheral axial annular protrusions 126, 128 and the central radial annular protrusion 130 are distinct from each other.

As can be taken from Figure 2 as well, the axial annular protrusions 126, 128 and the radial annular protrusions 132, 134 are defined partially by the respective electrically conductive layer structure 106, 108 and partially by the plating layers 122. In contrast to this, the radial annular protrusion 130 is defined partially by the electrically insulating layer structure 104 and partially by the plating layers 122. Any of the axial annular protrusions 126, 128 and the radial annular protrusions 130, 132, 134 may or may not have substantially constant cross-sections along a circumference of the through hole 120.

According to Figure 2, each of the radial annular protrusions 130, 132, 134 forms a local bottleneck of the through hole 120 so that the through hole 120 locally widens between adjacent ones of the annular protrusions 130, 132, 134. Furthermore, the through hole 120 has an inner diameter increasing in axial direction 162 from said electrically insulating layer structure 104 towards an axial middle portion 136 of each of said one electrically conductive layer structures 106, 108 and decreasing from said axial middle portion 136 in axial direction 162 further away from said electrically insulating layer structure 104.

Still referring to Figure 2, said electrically insulating layer structure 104 has, at a circumference thereof extending around the through hole 120, an irregularity 140 with respect to a respective planar main surface 112 of said electrically insulating layer structure 104. In the shown embodiment, the irregularity 140 is a circumferential notch or groove formed in a corner region between the upper main surface 112 and the lateral surface 170 of the electrically insulating layer structure 104. Such an irregularity 140 may be a relict of the mechanical drilling process for forming through hole 120. The plating layers 122 may partially fill said irregularity 140 of said electrically insulating layer structure 104. Another part of said irregularity 140 may be filled with material of electrically conductive layer structure 108.

In another embodiment, the plating layers 122 may cover only part of the opposing main surfaces 114, 116 of stack 102, for instance may end at positions corresponding to reference signs 168 in Figure 2. In such a configuration, the respective axial annular protrusions 126, 128 may form separated protruding islands around the respective extremity of the through hole 120.

**Figure 3** illustrates a cross-sectional image of an electronic board 100 according to an exemplary embodiment of the invention. The image of Figure 3 has been captured from a cross-section of a practically manufactured electronic board 100. As shown in Figure 3, many of the features described referring to Figure 2 are shown here as well.

Moreover, a respective section 138 of the lateral wall delimiting the respective through hole 120 and extending between the axial annular protrusion 126, 128 and the respective central radial annular protrusion 130 has a straight shape according to Figure 3.

As shown as well in Figure 3, said electrically insulating layer structure 104 has a diameter b smaller than a diameter B1 of said one electrically conductive layer structure 106, including said plating layers 122, between adjacent through holes 120, 120 and smaller than a diameter B2 of said further one electrically conductive layer structure 108, including said plating layers 122, between adjacent through holes 120, 120. A diameter of said one electrically conductive layer structure 106 may be different from or may be the same as a diameter of said further one electrically conductive layer structure 108.

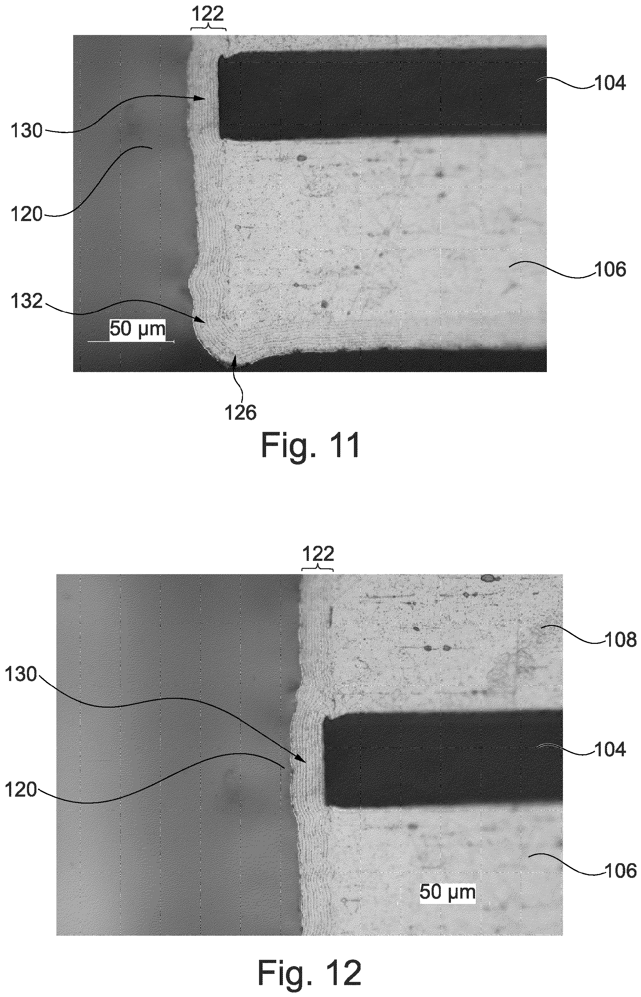

**Figure 4** illustrates a cross-sectional image of an electronic board 100 according to an exemplary embodiment of the invention. Figures 5 to 12 illustrate details of the image of the electronic board 100 according to Figure 4. Referring to **Figure 5****,** an upper right corner section of the left stack portion according to Figure 4 is shown in a detail. This detail shows the radial annular protrusion 134 in axial and radial direction, which was created by the mechanical drill bit. The radial annular protrusion 134 gets more pronounced by the applied plating layers 122. Referring to **Figure 6****,** an upper right corner section of the left-hand side electrically insulating layer structure 104 with irregularity 140 according to Figure 4 is shown in a detail. This may be created during the mechanical drilling process such that the material which shall be transported away and out of the drill hole can rip out some of the material of the electrically insulating layer structure 104 and thus such an irregularity 140 can be created. Referring to **Figure 7****,** a lower right corner section of the left stack portion according to Figure 4 is shown in a detail. Furthermore, the drill bit may shear the electrically insulating layer structure 104 in stacking direction. Therefore, a horn shaped irregularity 140 may be formed. Referring to **Figure 8****,** a central section of the left stack portion according to Figure 4 is shown in a detail around electrically insulating layer structure 104. A radial annular protrusion 130 may be formed by the electrically insulating layer structure 104 even without considering the included plating layers 122. Due to the mechanical drilling process, the electrically insulating layer structure 104 may radially protrude outwardly into the through hole 120. Without wishing to be bound to a specific theory, it is presently believed that this may result from a relaxation process of the material of the electrically insulating layer structure 104 as a reaction of the applied shear forces of the mechanical drilling process. Furthermore, an anchoring structure may be created around reference sign 140 and correspondingly on a bottom side of the electrically insulating layer structure 104, as well as in between. Such an anchoring structure increasing mechanical integrity of the electronic board 100 as a whole and may be created since the material may decrease its viscosity behavior due to the thermal impact of the drill bit. The material close to the drill bit may experience elevated temperatures and thus may start to polymerize, crosslink and/or cure. Furthermore, the drill bit is shearing the electrically insulating layer structure 104 towards the drill bit. The material behind may be more flexible, and after the drilling process the materials may tend to relax to the initial positions. However, the cured portion may be unable to relax since it may have lost its flexible behavior due to the curing. Therefore, this kind of bottleneck or anchor structure may be created. Referring to **Figure 9****,** an upper right corner section of the left stack portion according to Figure 4 is shown in a further detail. Referring to **Figure 10****,** a lower right corner section of the left stack portion according to Figure 4 is shown in a detail. Referring to **Figure 11****,** a lower left corner section of the right stack portion according to Figure 4 is shown in a detail. Referring to **Figure 12****,** a central section of the right stack portion according to Figure 4 is shown in a detail around electrically insulating layer structure 104.

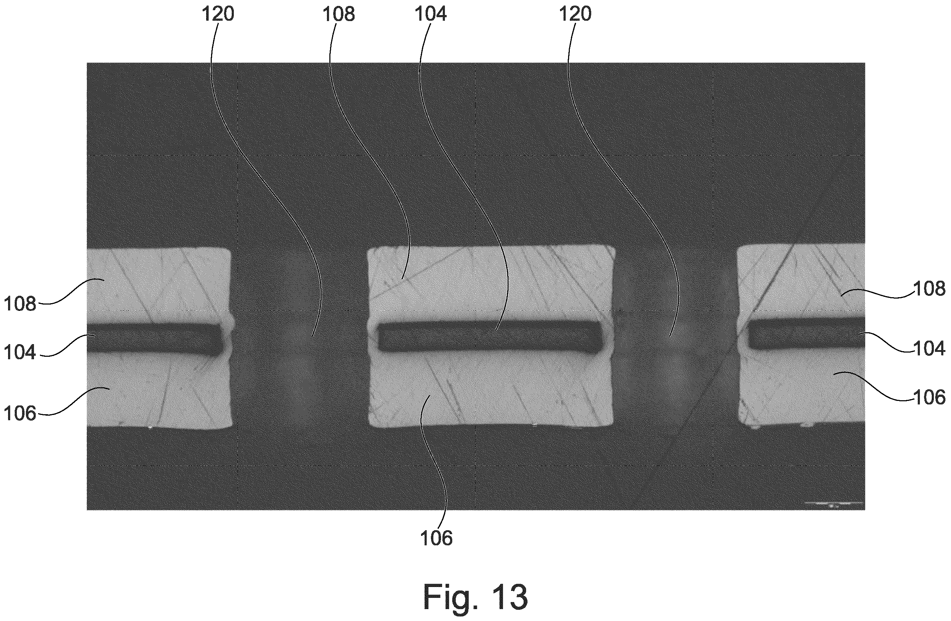

**Figure 13** illustrates a cross-sectional image of an electronic board 100 according to an exemplary embodiment of the invention. Figure 13 shows three stacks sections between two through holes 120.

**Figure 14** illustrates a cross-sectional image of an electronic board 100 according to an exemplary embodiment of the invention.

In Figure 14, a grinding tool is schematically illustrated with reference sign 170. Grinding tool 170 presently grinds the lower main surface of the electronic board 100 or a preform thereof. By removing selectively material from the axial annular protrusion 126 at the bottom side of the stack 102 by grinding, a discontinuous plating layers structure is formed, as indicated by reference sign 172. Thus, at a circumference of the through hole 120, a part of the plurality of plating layers 122', 122" extends discontinuously at the lower main surface 114 of the stack 102. Consequently, one edge of electrically conductive layer structure 106 covered by the plating layers 122 is sharp, see reference sign 176.

Although not shown in Figure 14, this may be correspondingly the case with the electrically conductive layer structure 108. Thus, an edge of each respective of the electrically conductive layer structures 106, 108 covered by the plating layers 122 may be sharp.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. An electronic board (100), which comprises:
a stack (102) comprising at least one electrically insulating layer structure (104) and a plurality of electrically conductive layer structures (106, 108), wherein one of said plurality of electrically conductive layer structures (106) is provided on one main surface (110) of said at least one electrically insulating layer structure (104) and a further one of said plurality of electrically conductive layer structures (108) is provided on an opposing further main surface (112) of said at least one electrically insulating layer structure (104);
a through hole (120) formed in the stack (102) and being laterally delimited by conductive material;
at least one plating layer (122) provided on at least part of both opposing main surfaces (114, 116) of the stack (102) and on a lateral wall (118) of the stack (102);
an axial annular protrusion (126, 128) provided at one extremity of the through hole (120); and
a radial annular protrusion (130, 132, 134) provided at the lateral wall (118) of the stack (102).

2. The electronic board (100) according to claim 1, wherein the axial annular protrusion (126, 128) is defined at least partially by said one electrically conductive layer structure (106) and/or by said further one electrically conductive layer structure (108) and/or by the at least one plating layer (122), and/or wherein the radial annular protrusion (130, 132, 134) is defined at least partially by said one electrically conductive layer structure (106) and/or by said further one electrically conductive layer structure (108) and/or by the at least one plating layer (122).

3. The electronic board (100) according to any of claims 1 to 2, wherein the axial annular protrusion (126, 128) and/or the radial annular protrusion (130, 132, 134) has substantially constant cross-sections along a circumference of the through hole (120).

4. The electronic board (100) according to any of claims 1 to 3, wherein the electronic board (100) comprises a plurality of through holes (120) in the stack (102), wherein the at least one plating layer (122) is provided on a lateral wall (118) of the stack (102) delimiting each of the through holes (120), and each through hole (120) having a respective axial annular protrusion (126, 128) provided at one extremity of the respective through hole (120) and having a respective radial annular protrusion (130, 132, 134) provided at the lateral wall (118) of the stack (102) delimiting the respective through hole (120).

5. The electronic board (100) according to any of claims 1 to 4, wherein the axial annular protrusion (126, 128) extends from the lateral wall (118) of the stack (102).

6. The electronic board (100) according to any of claims 1 to 5, wherein the at least one plating layer (122) comprises a plurality of stacked plating layers (122', 122"), wherein in particular an outermost of said plating layers (122', 122") comprises a material being different from another material of one or more inner ones of said plating layers (122', 122").

7. The electronic board (100) according to any of claims 1 to 6, wherein the at least one plating layer (122), in particular comprising a seed layer (122') and at least one further plating layer (122") thereon, forms at least part of the axial annular protrusion (126, 128) and/or of the radial annular protrusion (130, 132, 134).

8. The electronic board (100) according to any of claims 1 to 7, wherein said electrically insulating layer structure (104) has, at a circumference thereof extending around the through hole (120), an irregularity (140) with respect to a respective planar main surface (112) of said electrically insulating layer structure (104), wherein in particular a part of said at least one plating layer (122) at least partially fills said irregularity (140) of said electrically insulating layer structure (104).

9. The electronic board (100) according to any of claims 1 to 8, wherein said electrically insulating layer structure (104) has a diameter (b) smaller than a diameter (B1) of said one electrically conductive layer structure (106), including said at least one plating layer (122), and/or smaller than a diameter (B2) of said further one electrically conductive layer structure (108), including said at least one plating layer (122).

10. The electronic board (100) according to any of claims 1 to 9, wherein said electrically insulating layer structure (104) is made of a plastic material, in particular polyimide.

11. The electronic board (100) according to any of claims 1 to 10, wherein the at least one plating layer (122) comprises a plurality of plating layers (122', 122"), and wherein at a circumference of the through hole (120) at least one of the plurality of plating layers (122', 122") does not extend or discontinuously extends at at least one of the main surfaces (114, 116) of the stack (102).

12. The electronic board (100) according to any of claims 1 to 11, wherein one edge of one of the plurality of electrically conductive layer structures (106, 108) covered by the at least one plating layer (122) is sharp, and/or wherein an edge of each respective of the electrically conductive layer structures (106, 108) covered by the at least one plating layer (122) is sharp.

13. A method of manufacturing an electronic board (100), wherein the method comprises:
providing a stack (102) comprising at least one electrically insulating layer structure (104) and a plurality of electrically conductive layer structures (106, 108), wherein one of said plurality of electrically conductive layer structures (106) is provided on one main surface (110) of said at least one electrically insulating layer structure (104) and a further one of said plurality of electrically conductive layer structures (108) is provided on an opposing further main surface (112) of said at least one electrically insulating layer structure (104);
forming a through hole (120) in the stack (102);
forming at least one plating layer (122) on at least part of both opposing main surfaces (114, 116) of the stack (102) and on a lateral wall (118) of the stack (102);
forming an axial annular protrusion (126, 128) at one extremity of the through hole (120); and
forming a radial annular protrusion (130, 132, 134) at the lateral wall (118) of the stack (102).

14. The method according to claim 13, wherein the method comprises forming the through hole (120) in the stack (102) by mechanically drilling.

15. The method according to claim 13 or 14, wherein the method comprises forming the through hole (120) in the stack (102) while the stack (102) is arranged between a bottom protection structure (144) and a top protection structure (146).
